# EUROPEAN PATENT APPLICATION

(11) **EP 4 488 411 A1**
(43) Date of publication of application: **08.01.2025**
(21) Application number: 23763281.5
(22) Date of filing: 17.02.2023
(51) Int. Cl.: C23F 1/08, H05K 3/06

(54) **CIRCUIT BOARD, METHOD FOR MANUFACTURING CIRCUIT PATTERN, AND ETCHING DEVICE**

(30) Priority: 01.03.2022 JP 2022031322; 01.03.2022 JP 2022031339
(71) Applicant: NHK Spring Co., Ltd., Yokohama-shi, Kanagawa 236-0004 (JP)
(72) Inventor: YANO, Shinya, Yokohama-shi, Kanagawa 236-0004 (JP); UETAKE, Misao, Hachioji-shi, Tokyo 192-0154 (JP)
(74) Representative: TBK
(86) International application number: PCT/JP2023/005783
(87) International publication number: WO 2023/167022

(57) **Abstract**

There are provided a circuit board, a method for manufacturing a circuit board, and an etching device capable of suppressing side etching and suppressing a takt time even when etching is performed on a thick workpiece.

An etching device (1A) includes a conveyance means that conveys a workpiece (W), a spray pipe (3) that extends along a conveyance direction of the workpiece (W) by the conveyance means and feeds an etching solution, a plurality of spray nozzles (2) capable of injecting the etching solution to the workpiece (W) and provided in the spray pipe (3) in a row in the conveyance direction, and a movement means that is capable of moving the spray pipe (3) in a conveyance orthogonal direction orthogonal to the conveyance direction, and moves the spray pipe (3) so that the etching solution injected from the spray nozzles (2) is sprayed to the workpiece (W) over the entire predetermined region in the conveyance orthogonal direction.

## Description

### Technical Field

The present invention relates to a circuit board, a method for manufacturing a circuit pattern, and an etching device.

### Background Art

Conventionally, various circuit boards have been used. In recent years, there is an increasing opportunity to use a circuit board through which a large current flows for a high-luminance LED or a power module. In order to make the circuit board compatible with a large current, it is effective to reduce a resistance value and to increase a thickness of a circuit pattern so as to ensure sufficient heat dissipation when a large current flows.

Patent Literature 1 is known as a technique for manufacturing a circuit board with a thick circuit pattern. This manufacturing method includes the processes of forming a circuit pattern on one surface of a copper plate by half etching, stacking a prepreg on the formed circuit pattern, and further forming the rest of the circuit pattern on a surface (unprocessed side) opposite to the prepreg.

### Citation List

### Patent Literature

Patent Literature 1: JP 3806294 B2
Patent Literature 2: JP H10-18057 A

### Summary of Invention

### Technical Problem

However, when the circuit board is manufactured by the technique of Patent Literature 1, since half etching is performed from both the one surface side and the other surface side of the copper plate, the process becomes complicated and the takt time becomes long, and accordingly, the manufacturing cost increases. On the other hand, when a circuit pattern is to be formed by etching from one surface side of a copper plate, in a conventional etching device (see Patent Literature 2 and Figs. 6A to 6C in the accompanying drawings), a trail (side etching) increases as the thickness of the copper plate increases, and thus a sufficient circuit width cannot be secured.

In view of such conventional problems, an object of the present invention is to provide a circuit board, a method for manufacturing a circuit pattern, and an etching device capable of suppressing side etching and suppressing a takt time even when etching is performed on a thick workpiece such as a circuit pattern of a large-current circuit board.

### Solution to Problem

The present invention is an etching device that performs etching on a predetermined region of a workpiece by injecting an etching solution to the workpiece, the etching device including a conveyance means that conveys the workpiece, a spray pipe that extends along a conveyance direction of the workpiece by the conveyance means and feeds the etching solution, a plurality of spray nozzles capable of injecting the etching solution to the workpiece and provided in the spray pipe in a row in the conveyance direction, and a movement means that is capable of moving the spray pipe in a conveyance orthogonal direction orthogonal to the conveyance direction, and moves the spray pipe so that the etching solution injected from the spray nozzles is sprayed to the workpiece over the entire predetermined region in the conveyance orthogonal direction.

In the etching device described above, it is preferable that the spray nozzle has an elongated spray pattern, and is provided in the spray pipe in a state where a longitudinal direction of the spray pattern is along the conveyance orthogonal direction.

In the etching device described above, it is preferable that the conveyance means includes an attitude changing means that changes an attitude of the workpiece so that a side positioned in the conveyance direction is a side positioned in the conveyance orthogonal direction in a middle part of the conveyance path.

In the etching device described above, it is preferable that the spray nozzle has an elongated spray pattern, and the spray pipe includes a first portion provided with the spray nozzle in a state where a longitudinal direction of the spray pattern is along the conveyance direction, and a second portion provided with the spray nozzle in a state where the longitudinal direction of the spray pattern is along the conveyance orthogonal direction.

Further, the present invention is a method for manufacturing a circuit pattern of a circuit board by etching a predetermined region of a workpiece by an etching device that injects an etching solution to the workpiece, the etching device including a conveyance means that conveys the workpiece, a spray pipe that extends along a conveyance direction of the workpiece by the conveyance means and feeds the etching solution, a plurality of spray nozzles capable of injecting the etching solution to the workpiece and provided in the spray pipe in a row in the conveyance direction, and a movement means that moves the spray pipe with respect to a conveyance orthogonal direction orthogonal to the conveyance direction, the method including causing the conveyance means to convey the workpiece while injecting the etching solution from the spray nozzles, and causing the movement means to move the spray pipe so that the etching solution injected from the spray nozzles is sprayed to the workpiece over the entire predetermined region in the conveyance orthogonal direction, thereby manufacturing the circuit pattern.

Further, the present invention is a circuit board including a circuit pattern formed by etching, in which an etching depth of the circuit pattern is 0.5 to 2.0 mm, and an etching factor of the circuit pattern is equal to or more than 5.

### Advantageous Effects of Invention

According to the present invention, even when etching is performed on a thick workpiece, side etching can be suppressed, and the takt time can also be suppressed.

### Brief Description of Drawings

Fig. 1A is a front view illustrating a first embodiment of an etching device according to the present invention.
Fig. 1B is a plan view illustrating the first embodiment of the etching device according to the present invention.
Fig. 1C is a side view illustrating the first embodiment of the etching device according to the present invention.
Fig. 2 is a plan view illustrating a second embodiment of the etching device according to the present invention.
Fig. 3 is a plan view illustrating a third embodiment of the etching device according to the present invention.
Fig. 4A is a view illustrating an embodiment of a circuit board.
Fig. 4B is a view illustrating an embodiment of a circuit board.
Fig. 5A is a view for describing a principle capable of further suppressing a side etching amount.
Fig. 5B is a view for explaining a principle capable of further suppressing the side etching amount.
Fig. 5C is a view for explaining a principle capable of further suppressing the side etching amount.
Fig. 5D is a view for explaining a principle capable of further suppressing the side etching amount.
Fig. 6A is a front view illustrating a conventional etching device.
Fig. 6B is a plan view illustrating a conventional etching device.
Fig. 6C is a side view illustrating a conventional etching device.

### Description of Embodiments

Hereinafter, embodiments of a circuit board, a method for manufacturing a circuit pattern, and an etching device according to the present invention will be described with reference to the accompanying drawings. Note that the drawings illustrated in the accompanying drawings are schematic, and the thickness and width of each portion, the ratio between the portions, and the like may be different from those actually implemented.

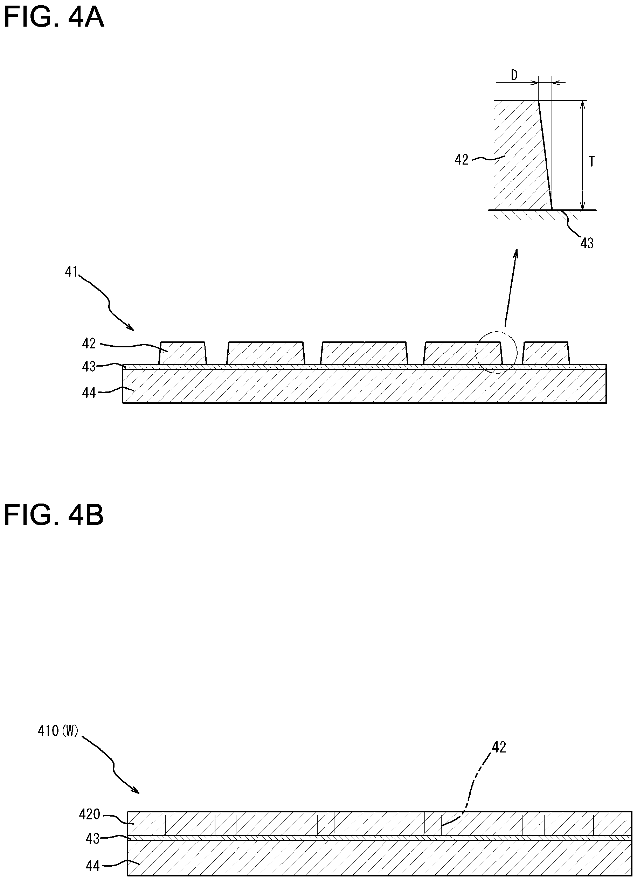

First, a circuit board as an example of a product of an etching device according to the present invention will be described with reference to Fig. 4A. A circuit board 41 of the present embodiment is formed by stacking a circuit pattern 42, an insulating layer 43, and a base substrate 44 in this order.

The circuit pattern 42 is formed by etching plate-shaped metal with an etching device described later into a predetermined pattern. The circuit pattern 42 of the present embodiment is formed by thick copper (rolled copper). Further, a thickness T (thickness of thick copper) of the circuit pattern 42 is 0.5 to 2.0 mm.

The insulating layer 43 is formed by a material having an insulating property, and serves to electrically insulate the circuit pattern 42 and the base substrate 44 and to adhere them to each other. The insulating layer 43 may cover the entire surface of the base substrate 44 or a part of the surface.

Examples of the material of the insulating layer 43 include a resin composition containing a thermosetting resin. Examples of the thermosetting resin include an epoxy resin, a phenol resin, a melamine resin, a urea resin, an unsaturated polyester resin, an alkyd resin, a cyanate resin, and the like. One thermosetting resin may be used alone, or two or more thermosetting resins may be used in combination. Examples of those contained in the resin composition other than the thermosetting resin include a curing agent. The curing agent is not particularly limited as long as it is selected according to the type of thermosetting resin and reacts with the thermosetting resin. Examples of the curing agent in the case of using an epoxy resin include an amine-based curing agent, an imidazole-based curing agent, a phenol-based curing agent, and the like. The resin composition may contain a filler (inorganic filler). The filler is preferably one having excellent insulation properties and high thermal conductivity, and examples thereof include aluminum oxide, silica, aluminum nitride, boron nitride, silicon nitride, magnesium oxide, and the like. The resin composition may further contain a curing accelerator, a stabilizer, an ion scavenger, a solvent, and the like. The resin composition may contain a softness imparting material.

The base substrate 44 can be formed by various materials but is preferably formed by a material having a high thermal conductivity in particular, and is preferably formed by, for example, a metal such as copper, aluminum, or iron (may be a simple metal or an alloy). The base substrate 44 of the present embodiment has a plate shape, but may be provided with fins or the like in order to enhance the effect of releasing heat to the outside. Further, the base substrate 44 may have a single layer structure or a multilayer structure.

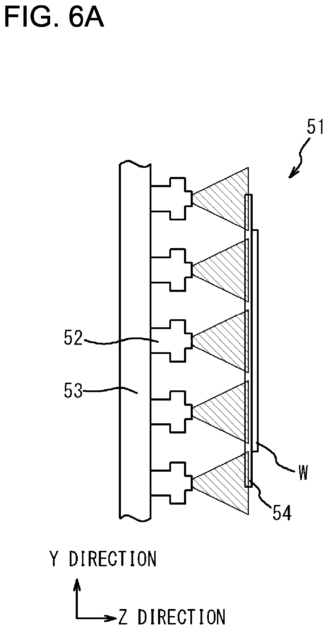

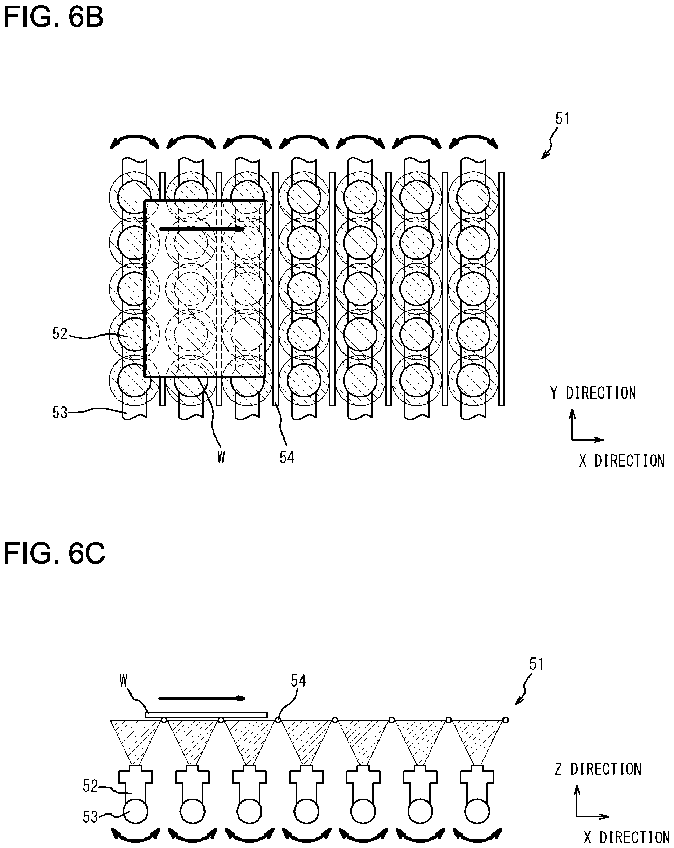

Next, a conventional etching device confirmed to complete the present invention will be described with reference to Figs. 6A to 6C.

A conventional etching device 51 illustrated in Figs. 6A to 6C has been frequently used, for example, when a thin circuit pattern is formed by etching. The etching device 51 includes a spray nozzle 52 that injects an etching solution (for example, ferric chloride solution) toward the workpiece W. The spray nozzle 52 uses a so-called filled-conical nozzle in which a spray pattern when sprayed onto a flat surface is circular, and is attached to a spray pipe 53 that supplies an etching solution. The spray pipe 53 extends along a Y direction in Figs. 6A to 6C, and a plurality of spray nozzles 52 is attached in series in the Y direction with respect to one spray pipe 53. The spray pipe 53 is configured to be swingable about each central axis by a swinging means which is not illustrated. Further, as illustrated in Fig. 6B, a plurality of spray pipes 53 is provided at intervals in an X direction. That is, the spray nozzles 52 are arranged at intervals in the X direction and the Y direction in plan view. Note that the intervals between the spray nozzles 52 in the X direction and the Y direction are relatively tightly packed so that no gap is generated between the individual spray liquids sprayed to the workpiece W (so that the spray patterns overlap each other) when the spray pipe 53 is swung while spraying the spray liquid from the spray nozzles 52.

Furthermore, the etching device 51 includes a plurality of rollers 54 extending in the Y direction and arranged at intervals in the X direction above the spray nozzles 52. The workpiece W to be etched is placed on the rollers 54. As the rollers 54 rotate, the workpiece W placed on the rollers 54 is conveyed in the X direction illustrated in Figs. 6A to 6C. Note that the X direction corresponds to a "conveyance direction" in the present specification and the like, and the Y direction corresponds to a "conveyance orthogonal direction".

For the etching device 51 having such a configuration, as illustrated in Fig. 4B, an unprocessed circuit board 410 in which a thick copper 420 before being processed as the circuit pattern 42 is stacked on the insulating layer 43 is prepared as the workpiece W, and a test of forming the circuit pattern 42 by performing etching by injecting an etching solution from the spray nozzles 52 while conveying the workpiece W by the rollers 54 was performed. Note that although not illustrated, a resist material (dry film resist in the present embodiment) is stacked on the surface of the thick copper 420. Further, the range of the circuit pattern 42 varies in size and shape depending on the circuit configuration, the type of electronic component mounted on the circuit configuration, and the like, and may be provided in the entire region in the X direction and the Y direction with respect to the thick copper 420 or may be provided only in a partial region, but in the present test, the range is provided in the entire region in the X direction and the Y direction with respect to the thick copper 420. That is, the etching solution is sprayed to the entire region of the thick copper 420 in the X direction and the Y direction. The thickness of the thick copper 420 in the workpiece W used in the test is 1.5 mm.

However, when the workpiece W is etched by the conventional etching device 51, the time required for etching the thick copper 420 to a predetermined depth (the time required for etching until the insulating layer 43 is exposed in the test) is large. In addition, when the circuit pattern 42 after etching was confirmed, the side etching amount (the length D illustrated in Fig. 4A) was excessively large and the intended etching factor (the value of T/D illustrated in Fig. 4A) was not obtained, and the variation in the etching factor was also large.

On the other hand, the inventors of the present application conducted studies on these problems, and found that a temperature and a pressure of the etching solution sprayed from the spray nozzles 52, a distance from the spray nozzles 52 to the workpiece W, an individual difference of the spray nozzles 52, a difference in an overlapping state of the etching solution sprayed to the workpiece W, and the like lead to defects. The present inventors have further studied and found that the above problems can be solved, and completed the present invention.

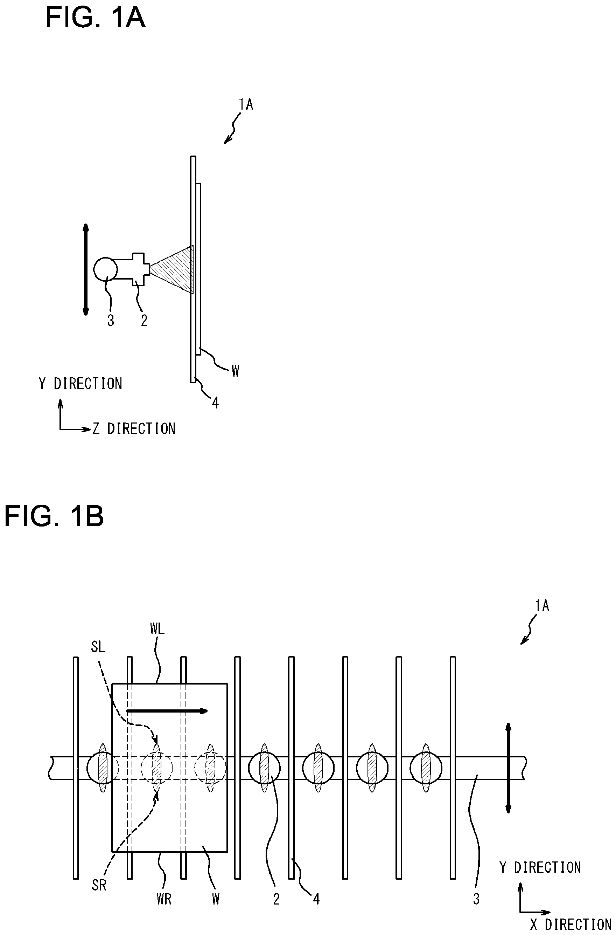

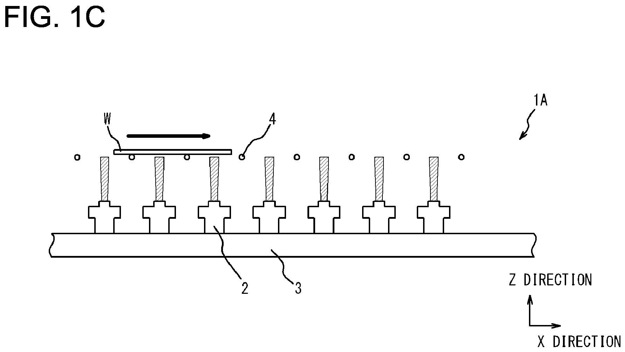

Hereinafter, an etching device 1A as a first embodiment of an etching device according to the present invention will be described with reference to Figs. 1A to 1C. The etching device 1A includes a spray nozzle 2 that sprays an etching solution such as a ferric chloride solution upward and blows the etching solution to the workpiece W. Note that the workpiece W illustrated in Figs. 1A to 1C is the same as the workpiece W illustrated in Figs. 4B and 6A to 6C described above. The spray nozzles 2 of the present embodiment use a so-called fan-shaped nozzle having an elongated spray pattern. The spray nozzles 2 are attached to one spray pipe 3 that supplies the etching solution. The spray pipe 3 of the present embodiment extends along the X direction in Figs. 1A to 1C, and a plurality of spray nozzles 2 is attached to the spray pipe 3 in series in the X direction. Note that the spray nozzles 2 are attached to the spray pipe 3 in a state where a longitudinal direction of the spray pattern is along the Y direction.

In addition, the etching device 1A includes a movement means, not illustrated, that moves the spray pipe 3 along the Y direction. The movement means can include, for example, a guide shaft extending along the Y direction, a slider slidably held by the guide shaft and attached to the spray pipe 3, a drive belt connected to the slider and extending along the Y direction, a motor for rotating the drive belt, and the like. The range in which the spray pipe 3 is moved in the Y direction by the movement means is at least a range in which the etching solution is sprayed to the entire region in the Y direction with respect to the region of the workpiece W where the circuit pattern 42 is provided. That is, since the circuit pattern 42 of the present embodiment is provided in the entire region of the thick copper 420 of the workpiece W in the Y direction, the spray pipe 3 is moved at least between the position where a left end SL of the spray pattern overlaps a left end WL of the workpiece W and the position where a right end SR of the spray pattern overlaps a right end WR of the workpiece W in the state illustrated in Fig. 1B.

Further, the etching device 1A includes a plurality of rollers 4 extending in the Y direction and arranged at intervals in the X direction above the spray nozzle 2. The rollers 4 are disposed so as not to overlap the spray nozzles 2 in plan view. Further, the rollers 4 each have a rod shape having a circular outer shape, and can rotate around its central axis. As a rotation mechanism for rotating the rollers 4, for example, pulleys are attached to the respective rollers 4, a drive belt is rotated around the pulleys, and the drive belt is rotated by a motor. Note that the roller 4 and the rotation mechanism of the present embodiment correspond to "conveyance means" in the present specification and the like.

The etching device 1A having such a configuration can etch the workpiece W by moving the spray pipe 3 in the Y direction while injecting the etching solution from the spray nozzles 2 while rotating the rollers 4 to convey the workpiece W in the X direction.

As described above, the defects that have occurred in the conventional etching device 51 are caused by, for example, individual differences of the spray nozzles 52, differences in the overlapping state of the etching solution blown onto the workpiece W, and the like. On the other hand, the etching device 1A has a configuration in which the plurality of spray nozzles 2 is arranged in series in the X direction in one spray pipe 3, and the etching solution is sprayed onto the workpiece W by moving the spray pipe 3 in the Y direction, so that it is possible to suppress the influence due to the individual difference of the spray nozzles 2 and the difference in the overlapping state of the etching solution sprayed onto the workpiece W, whereby it is possible to increase the etching factor by suppressing the side etching. In addition, the time required for etching can be shortened by employing the above-described new configurations of the spray nozzle 2, the spray pipe 3, and the like (in particular, the spray pattern in the spray nozzle 2 is elongated, and the spray liquid is locally sprayed onto the workpiece W, so that the spray liquid driving force is increased), and appropriately adjusting the temperature and pressure of the etching solution injected from the spray nozzle 2, the distance from the spray nozzle 2 to the workpiece W, and the like. Note that the test by the etching device 1A will be described in detail later.

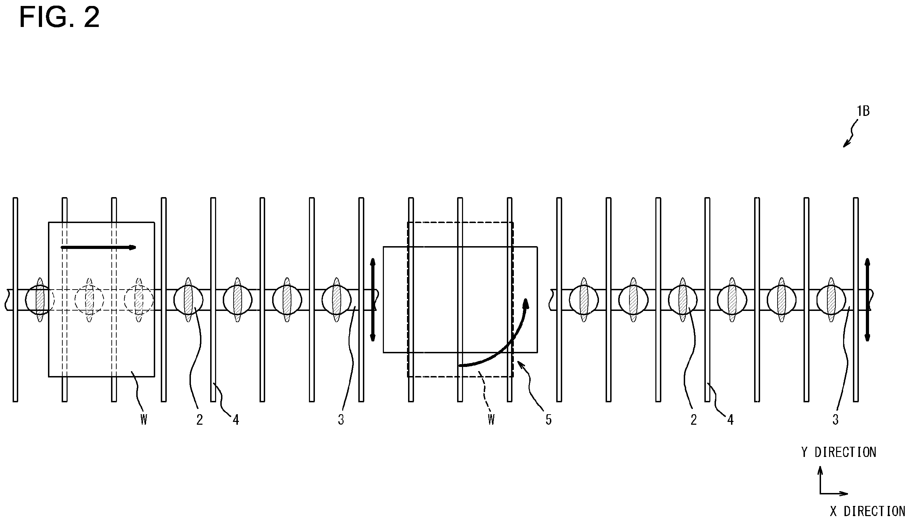

Incidentally, as a result of repeated studies using the etching device 1A, it has been found that the value in the X direction tends to be larger than the value in the Y direction as described later although the side etching amount D is suppressed as compared with the case of performing etching with the conventional etching device 51. Further studies have been made to improve this point, and it has been found that the side etching amount D can be kept equal to the value in the Y direction even in the X direction with the configuration of the etching device 1B illustrated in Fig. 2.

Here, the etching device 1B of Fig. 2 will be described. The etching device 1B according to the present embodiment has the same basic configuration as the etching device 1A described above, but is different from the etching device 1A in that an attitude changing means 5 that changes the attitude of the workpiece W is provided in the middle of the conveyance path including the plurality of rollers 4. The attitude changing means 5 changes the attitude of the workpiece W so that the side located in the X direction is the side located in the Y direction. Examples of the attitude changing means 5 include a transfer machine (movable in a vertical direction and rotatable about a vertical axis, and configured to be capable of raising the workpiece W by a workpiece attracting unit provided at a distal end portion, then rotate the workpiece W by 90 degrees about the vertical axis, and further lower the workpiece W to an original height) provided above the workpiece W and a rotary table (rotatable around a vertical axis, and configured to rotate by 90 degrees in a state where the workpiece W is placed when the workpiece W is conveyed by the rollers 4) on which the workpiece W conveyed by the rollers 4 is placed.

Note that, in the etching device 1B illustrated in Fig. 2, the spray pipe 3 is separated on the upstream side and the downstream side in the conveyance direction with respect to the attitude changing means 5, but may be integrally connected.

With the etching device 1B having such a configuration, the workpiece W etched on the upstream side in the conveyance direction with respect to the attitude changing means 5 is etched on the downstream side in the conveyance direction after the attitude of the workpiece W is changed by 90 degrees by the attitude changing means 5. That is, even if the side etching amount D is becoming larger in the X direction than in the Y direction when the workpiece W is etched on the upstream side in the conveyance direction, the side etching amount D at the original portion in the X direction can be suppressed when the etching is continuously performed on the downstream side in the conveyance direction after the attitude change. Therefore, the side etching amount D when the etching is finally performed to a predetermined depth can be made equal to the value of the portion located in the Y direction even in the portion originally located in the X direction. Note that, in the etching device 1B of the present embodiment, the conveyance distance of the workpiece W on the upstream side in the conveyance direction is longer than the conveyance distance of the workpiece W on the downstream side in the conveyance direction (that is, the time for etching the workpiece W on the upstream side in the conveyance direction is longer than the time for etching the workpiece W on the downstream side in the conveyance direction), and it is configured to perform the main etching on the upstream side in the conveyance direction, and perform the etching to suppress the side etching amount D at the portion in the original X direction on the downstream side in the conveyance direction.

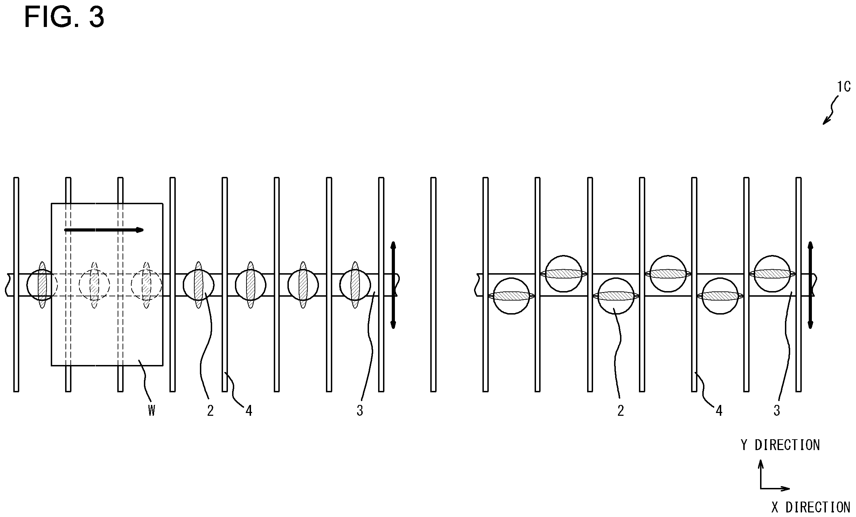

In order to make the value in the X direction of the side etching amount D equal to the value in the Y direction, it can be achieved by the etching device 1C illustrated in Fig. 3. The etching device 1C of the present embodiment changes the direction of the spray nozzles 2 in the middle of the conveyance path including the plurality of rollers 4. Specifically, on the upstream side in the conveyance direction, the spray nozzles 2 are attached to the spray pipe 3 with the longitudinal direction of the spray pattern along the Y direction, but on the downstream side in the conveyance direction, the spray nozzles 2 are attached with the longitudinal direction of the spray pattern along the X direction. In order to prevent the spray patterns of the adjacent spray nozzles 2 from overlapping each other in the X direction, the spray nozzles 2 on the downstream side in the conveyance direction in the present embodiment are attached to the spray pipe 3 so as to be staggered as a whole by being shifted in the Y direction every other spray nozzle 2 when the spray nozzles 2 are arranged in the direction along the X direction.

Note that, in the spray pipe 3 illustrated in Fig. 3, a portion to which the spray nozzles 2 are attached in a state where the longitudinal direction of the spray pattern is along the Y direction (portion on the upstream side in the conveyance direction) corresponds to a "second portion" in this specification and the like, and a portion to which the spray nozzles 2 are attached in a state where the longitudinal direction of the spray pattern is along the X direction (portion on the downstream side in the conveyance direction) corresponds to a "first portion" in this specification and the like. Further, the spray pipe 3 in Fig. 3 is separated on the upstream side and the downstream side in the conveyance direction, but may be integrally connected.

With the etching device 1C having such a configuration, the etching is performed by the etching solution ejected from the spray nozzles 2 in a state where the longitudinal direction of the spray pattern is along the Y direction on the upstream side in the conveyance direction, and the etching is performed by the etching solution ejected from the spray nozzles 2 in a state where the longitudinal direction of the spray pattern is along the X direction on the downstream side in the conveyance direction. That is, even if the side etching amount D is becoming larger in the X direction than in the Y direction when the workpiece W is etched on the upstream side in the conveyance direction, the side etching amount D at the original portion in the X direction can be suppressed when the etching is performed on the downstream side in the conveyance direction. Therefore, similarly to the etching device 1B, also in the etching device 1C, the side etching amount D when etching is finally performed to a predetermined depth can be kept equal to the value in the Y direction even in the X direction.

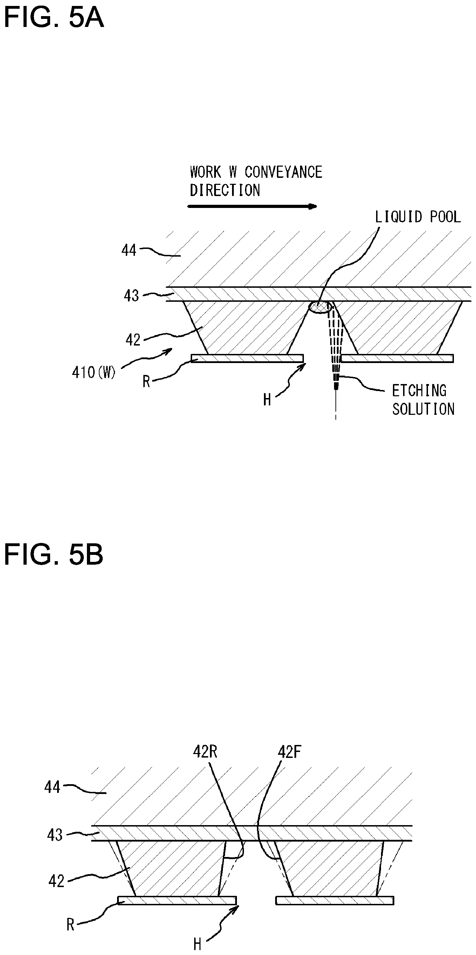

Incidentally, as a result of repeated studies by the inventor of the present application, it has been found that the side etching amount D can be further suppressed by the injection angle of the spray nozzles 2. This point will be described with reference to Figs. 5A to 5D.

Fig. 5A is a view illustrating a situation in which the circuit board 410 illustrated in Fig. 4B is used as the workpiece W and etching is performed by the etching device 1B of Fig. 2. Note that Reference Sign R in Fig. 5A represents a resist material (dry film resist in the present embodiment), and Reference Sign H represents an opening of the resist material R. Incidentally, in the etching device 1B illustrated in Fig. 2, the spray nozzles 2 inject the etching solution toward directly above (in the Z direction). When the etching was performed up to the end in this state, in the circuit pattern 42, as illustrated in Fig. 5B, the side etching amount D of the traveling direction head side portion 42F in the same opening H was larger than the side etching amount D of the traveling direction tail portion 42R. As a result of investigation on the cause, it has been found that the etching solution entering from the opening H forms a liquid pool inside the opening H, and as a result of conveying the workpiece W in this state, the etching in the traveling direction tail portion 42R that easily contacts the liquid pool proceeds more easily than the traveling direction head side portion 42F.

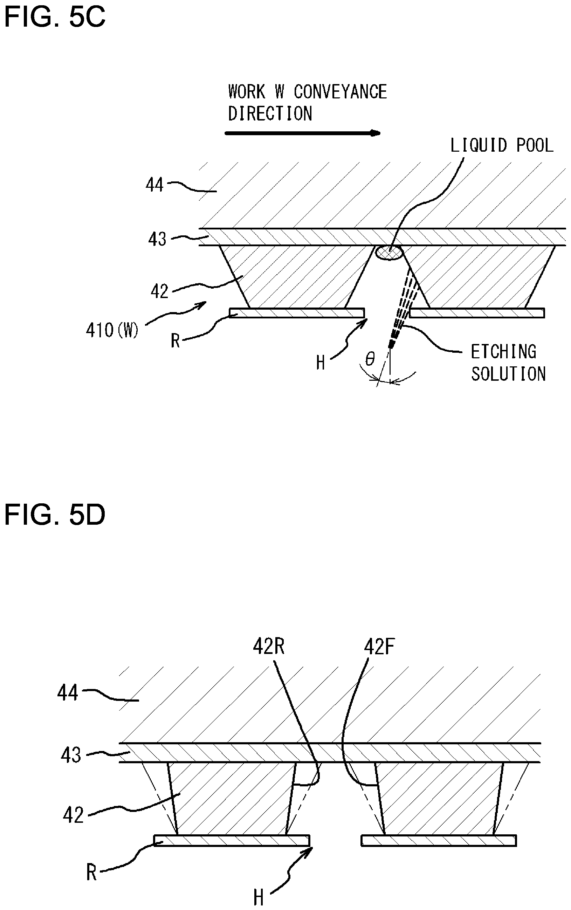

On the other hand, when etching is performed to some extent with the spray nozzles 2 facing directly upward, and then, as illustrated in Fig. 5C, the etching solution is injected with the spray nozzle 2 whose injection angle is inclined toward the conveyance direction of the workpiece W, as illustrated in Fig. 5D, it is recognized that the side etching amount D of the traveling direction head side portion 42F can be suppressed to be equal to the side etching amount D of the traveling direction tail portion 42R. That is, since the injection angle of the spray nozzle 2 is inclined as illustrated, the etching solution easily comes into contact with the traveling direction head side portion 42F, and the liquid pool easily comes into contact with the traveling direction head side portion 42F.

Therefore, in a case where the side etching amount D is further suppressed, it is preferable to perform etching with the spray nozzles 2 whose injection angle is inclined toward the conveyance direction of the workpiece W in the latter half of the etching process. Note that, as a result of repeated studies on the injection angle of the spray nozzle 2, the preferable range of the injection angle θ with reference to the vertical direction illustrated in Fig. 5C was 10° ≤ θ ≤ 45°.

Hereinafter, test results when the thick copper 420 in the workpiece W is etched by the conventional etching device 51, the etching devices 1A, 1B, and 1C according to the embodiment of the present invention, and the etching device 1B in which the injection angle of the spray nozzles 2 is inclined in the latter half of the etching process will be described. The workpiece W used is the same in any test, the thickness of the thick copper 420 is 1.5 mm, and etching is performed until the insulating layer 43 is exposed. In any test, the etching solution is a ferric chloride solution. Note that, in addition to the temperature, the flow rate (injection amount), the pressure (injection speed), and the like of the etching solution injected from the spray nozzles 2 and 52, the distance from the spray nozzles 2 and 52 to the workpiece W, the conveying speed of the workpiece W, the moving speed of the spray pipe 3, and the like are set to optimized conditions so that the time required for etching can be shortened, and both suppression of the side etching amount D and improvement of the etching factor T/D can be achieved. As an example of the conditions, in the comparative example illustrated in Table 1 below, the flow rate to the spray nozzles 52 is set to 3 to 4 L/min and the pressure is set to 0.2 to 0.3 MPa, and in Example 1 to 4, the flow rate to the spray nozzle 2 is set to 5 to 6 L/min and the pressure is set to 0.4 to 0.5 MPa. When the test was performed under such conditions, the following results in Table 1 were obtained.

**[Table 1]**

| | Comparative example | Example 1 | Example 2 | Example 3 | Example 4 |
|---|---|---|---|---|---|
| Etching device used | Etching device 51 (Fig. 6) | Etching device 1A (Figs. 1A to 1C) | Etching device 1B (Fig. 2) | Etching device 1C (Fig. 3) | Etching device 1B (Fig. 2) + spray nozzle injection angle change |
| Side etching D of circuit pattern (X direction) | Large | 0.4 to 0.7 mm | 0.2 to 0.3 mm | 0.2 to 0.3 mm | 0.15 to 0.25 mm |
| Side etching D of circuit pattern (Y direction) | Large | 0.2 to 0.3 mm | 0.2 to 0.3 mm | 0.2 to 0.3 mm | 0.15 to 0.25 mm |
| Etching factor T/D of circuit pattern (X direction) | - | 3.5 to 2.1 | 7.5 to 5 | 7.5 to 5 | 10 to 6 |
| Etching factor T/D of circuit pattern (Y direction) | - | 7.5 to 5 | 7.5 to 5 | 7.5 to 5 | 10 to 6 |

As illustrated in the comparative example of Table 1, the circuit pattern 42 obtained by etching the workpiece W by the etching device 51 had a large side etching amount D. In addition, the time required for etching was also large. On the other hand, as illustrated in Examples 1 to 3, it was recognized that the side etching amount D can be suppressed when etching is performed by the etching devices 1A to 1C. In addition, it has been confirmed that the time required for etching is about several tens of minutes, and can be shorter than the time in the etching device 51. Note that, in a case where etching is performed by the etching device 1A, the side etching amount D tends to be larger in the X direction than in the Y direction, but as illustrated in Examples 2 and 3, when etching is performed by the etching devices 1B and 1C, it is recognized that the side etching amount D can be kept within 0.2 to 0.3 mm in both the X direction and the Y direction, and the etching factor T/D can be equal to or more than 5. When etching is performed by the etching device 1B in which the injection angle of the spray nozzle 2 is inclined in the latter half of the etching process, it has been recognized that the side etching amount D can be kept within 0.15 to 0.25 mm in both the X direction and the Y direction, and the etching factor T/D can equal to or more than 6. In addition, as the workpiece W, a workpiece having a thickness of the thick copper 420 in a range of 0.5 to 2.0 mm was prepared, and when a test of performing etching by the etching devices 1A to 1C until the insulating layer 43 was exposed was conducted, the same results as in Examples 1 to 4 were confirmed.

Although one embodiment of the present invention has been described above, the present invention is not limited to the specific embodiment, and various modifications and changes can be made within the scope of the gist of the present invention described in the claims unless otherwise limited in the above description. In addition, the effects of the above embodiment are merely examples of the effects caused by the present invention, and do not mean that the effects of the present invention are limited to the above effects.

For example, in the etching devices 1A to 1C, the spray nozzle 2 has a long and thin spray pattern, but the present invention is not limited thereto, and for example, a so-called filled pyramidal nozzle in which a spray pattern when sprayed on a flat surface has a square shape may be used. In a case where a filled pyramidal nozzle is used as the spray nozzle 2, two orthogonal sides of a square-shaped spray pattern are directed in the X direction and the Y direction, and the spray pattern is attached to the spray pipe 3. With such a filled pyramidal nozzle, it is possible to improve a phenomenon in which the side etching amount D generated in the spray nozzle 2 in which the above-described spray pattern becomes elongated becomes larger in the X direction than in the Y direction.

In addition, the configurations of the etching devices 1A to 1C can be changed as appropriate, and for example, a spray liquid may be sprayed onto the workpiece W from above. In the etching device 1C illustrated in Fig. 3, the arrangement of the spray nozzles 2 may be switched between the upstream side and the downstream side in the conveyance direction, and the longitudinal direction of the spray pattern may be along the X direction on the upstream side in the conveyance direction and the longitudinal direction of the spray pattern may be along the Y direction on the downstream side in the conveyance direction. In Fig. 3, the arrangement of the spray nozzles 2 is changed at two positions on the upstream side and the downstream side in the conveyance direction, but this may be further increased.

In addition, the circuit board 41 illustrated in Fig. 4A is not formed only by etching the one in which the thick copper 420 is stacked on the insulating layer 43 in advance as illustrated in Fig. 4B, but the circuit pattern 42 may be formed by etching the single thick copper 420 as the workpiece W and the circuit pattern may be stacked on the insulating layer 43.

Note that when the injection angle of the spray nozzle 2 is inclined toward the conveyance direction of the workpiece W as illustrated in Fig. 5C, etching at the traveling direction head side portion 42F may progress more than the traveling direction tail portion 42R depending on the shape of the circuit pattern 42. In this case, the injection angle of the spray nozzle 2 may be inclined in a direction opposite to the conveyance direction of the workpiece W, and the etching of the traveling direction tail portion 42R may be preferentially performed over the traveling direction head side portion 42F. In a case where the injection angle of the spray nozzle 2 is inclined in a direction opposite to the conveyance direction of the workpiece W, the injection angle θ based on the vertical direction illustrated in Fig. 5C is preferably set in a range of -10° ≤ θ ≤ -45°.

### Reference Signs List

1A, 1B, 1C Etching device
2 Spray nozzle
3 Spray Pipe
4 Roller (conveyance means)
5 Attitude changing means
41 Circuit board
42 Circuit pattern
W Workpiece

## Claims

1. A circuit board comprising a circuit pattern formed by etching, wherein
an etching depth of the circuit pattern is 0.5 to 2.0 mm, and an etching factor of the circuit pattern is equal to or more than 5.

2. A method for manufacturing a circuit pattern of a circuit board by etching a predetermined region of a workpiece by an etching device that injects an etching solution to the workpiece,
the etching device including
a conveyance means that conveys the workpiece,
a spray pipe that extends along a conveyance direction of the workpiece by the conveyance means and feeds the etching solution,
a plurality of spray nozzles capable of injecting the etching solution to the workpiece and provided in the spray pipe in a row in the conveyance direction, and
a movement means that moves the spray pipe with respect to a conveyance orthogonal direction orthogonal to the conveyance direction, the method comprising
causing the conveyance means to convey the workpiece while injecting the etching solution from the spray nozzles, and causing the movement means to move the spray pipe so that the etching solution injected from the spray nozzles is sprayed to the workpiece over the entire predetermined region in the conveyance orthogonal direction, thereby manufacturing the circuit pattern.

3. An etching device that performs etching on a predetermined region of a workpiece by injecting an etching solution to the workpiece, the etching device comprising:
a conveyance means that conveys the workpiece;
a spray pipe that extends along a conveyance direction of the workpiece by the conveyance means and feeds the etching solution;
a plurality of spray nozzles capable of injecting the etching solution to the workpiece and provided in the spray pipe in a row in the conveyance direction; and
a movement means that is capable of moving the spray pipe in a conveyance orthogonal direction orthogonal to the conveyance direction, and moves the spray pipe so that the etching solution injected from the spray nozzles is sprayed to the workpiece over the entire predetermined region in the conveyance orthogonal direction.

4. The etching device according to claim 3, wherein the spray nozzle has an elongated spray pattern, and is provided in the spray pipe in a state where a longitudinal direction of the spray pattern is along the conveyance orthogonal direction.

5. The etching device according to claim 4, wherein the conveyance means includes an attitude changing means that changes an attitude of the workpiece so that a side positioned in the conveyance direction is a side positioned in the conveyance orthogonal direction in a middle part of the conveyance path.

6. The etching device according to claim 3, wherein
the spray nozzle has an elongated spray pattern, and
the spray pipe includes a first portion provided with the spray nozzle in a state where a longitudinal direction of the spray pattern is along the conveyance direction, and a second portion provided with the spray nozzle in a state where the longitudinal direction of the spray pattern is along the conveyance orthogonal direction.
